# EUROPEAN PATENT APPLICATION

(11) **EP 2 139 032 A1**
(43) Date of publication of application: **30.12.2009**
(21) Application number: 08738890.6
(22) Date of filing: 26.03.2008
(51) Int. Cl.: H01L 21/60, C22C 5/02

(54) **HIGHLY RELIABLE GOLD ALLOY BONDING WIRE AND SEMICONDUCTOR DEVICE**

(30) Priority: 17.04.2007 JP 2007108733
(71) Applicant: Tanaka Denshi Kogyo K.K., Tokyo 100-6422 (JP)
(72) Inventor: MURAI, Hiroshi, Kanzaki-gun Saga 842-0031 (JP); CHIBA, Jun, Kanzaki-gun Saga 842-0031 (JP); AMADA, Fujio, Kanzaki-gun Saga 842-0031 (JP)
(74) Representative: Röthinger, Rainer
(86) International application number: PCT/JP2008/055702
(87) International publication number: WO 2008/132919

(57) **Abstract**

[Issues to be solved]

Providing enhanced bonding reliability of Au alloy bonding wire with low electrical resistivity to Al electrode of semiconductor device, and its application of semiconductor device is bonded with Al electrode pad by the same wire.

[Solution means]

Au alloy bonding wire comprising: 0.02 - 0.3 mass % Ag, total amount of 10 - 200 mass ppm at least one element of Ge and/or Si, and/or total amount of 10 - 200 mass ppm at least one element of Al and/or Cu, with residual of Au. Moreover, Al and/or Al alloy pad bonded with the above Au alloy bonding wire.

## Description

### FIELD OF THE INVENTION

The present invention relates to Au alloy bonding wire suitable for bonding with IC chip electrodes and such as outer leads of substrates using for semiconductor devices, and relates to the structure of bonding of this bonding wire in order to be bonded with Al and/or Al alloy. Especially, the present invention relates to the Au alloy bonding wire use for in-vehicle devices and for high-speed semiconductor devices under the hot environment. Also, the present invention relates to semiconductor devices that are using this bonding wire. And it relates to its structure of bonding of this bonding wire in order to be bonded with Al and/or Al alloy.

### STATE OF THE ART

Conventionally, as Au wire bonded with outer leads and IC chip pads of semiconductor devices, high purity Au wire, which purity is more than 99.99 mass % Au alloyed with other metallic additives, had been used widely because of its superiority at reliability. The one side of tip of this high purity Au wire is bonded with pure Al pad or Al alloy pad on IC chip electrode by the method of ultrasonic thermal compressed bonding, the other tip of the wire is connected with outer lead, then it becomes a semiconductor device after resin molding. These Al alloy pads are formed by the method of vacuum vapor deposition usually.

Whereas, resin molded semiconductor device using under such high temperature environment, which is required high reliability, as in the case of in-vehicle IC and RF IC at high working temperature, there are generated voids which are so called Kirkendall voids, cracks and corrosions causing by halogen additives included in sealing resin, they cause increase of the value of electrical resistance and decrease of mechanical bonding strength at bonded boundary between Al pad and/or Al alloy pad and pure Au wire. In general, it is used Al-Cu alloy, Al-Si alloy and Al-Si-Cu alloy as Al alloy pads. Hence, it is required to assure higher bonding reliability than before (sustainability of the value of electrical resistance and mechanical bonding strength by ball bonding at bonded boundary under some circumstances), Au-1 mass % Pd alloy as bonding wire had been used so far. Since Pd inhibits Au diffusion into Al pads at bonding boundary between Al alloy pad and pure Au wire under high temperature circumstances, formation of inter-metallic compound of Au₄Al, which is apt to corrode by halogen ingredient at bonding boundary, is relatively inhibited, and deterioration of bonding section between Al and/or Al alloy pad and Au alloy wire is inhibited, so this Au-Pd alloy wire has a merit which does not generate deterioration of bonding strength. Though this Au-1 mass % Pd alloy wire is superior at mechanical characteristics compared with pure Au-wire of purity of 99.99 mass % Au, the value of electrical resistivity as electrical characteristics of bonding wire is high. For instance, while the value of electrical resistivity of Au-wire of purity of 99.99 mass % Au is 2.3 micro-ohm-cm, the value of Au-1 mass % Pd alloy is 3.0 micro-ohm-cm. Therefore, when high-density packaging is going to be applied, device will malfunction by heat of wire, it may cause of breaking of wire, and also it will be concerned that response speed of signal will be delayed. When the bonding wire will be applied from 25 µm of diameter to thinner such as 15 µm, this tendency is strengthened increasingly. Moreover, in the case of Au-1 mass % Pd alloy, though the mechanism in detail is unknown, existence of Pd would be to promote oxidization of Aluminum at bonding boundary unexpectedly. For instance, from consequence of high temperature atmosphere test of Au-1 mass % Pd bonding wire without resin molding, more Al₂O₃ oxide is generated rather than Au bonding wire which purity of more than 99.99 mass % Au with partial additives, and then it becomes weak. This defect is fatal for a semiconductor device, so it had been an obstacle for practical use of Au-1 mass % Pd bonding wire because of less bonding reliability.

On the other hand, since Ag forms continuous solid solution with Au, the conception of using Au-Ag alloy as a bonding wire, had been well known from old days such as in Japanese Patent Application No. 1977-51867. Then, it had been tried to apply Au alloy with partial additive of Ag to purity of more than 99.99 mass % Au with partial additive of Ca and La, which are well known as enhancer of mechanical strength. This is a bonding wire for semiconductor device adding more than one of Ca, Y and one element of rare earth, and adding 0.05 - 0.95 mass % Ag, which forms continuous solid solution with Au, in order to obtain the almost same value of electrical resistivity of purity of more than 99.99 mass % Au ("Reference Patent 1" shown herein after). This bonding wire is Au alloy with inevitable impurity elements, including 0.05 - 0.95 mass % Ag and 0.001 -0.005 mass % of more than one element of Ca, Y and rare earth and residual Au. This bonding wire aims to provide alloyed wire for semiconductor device, which has higher strength and inhibits over increase of electrical resistivity, and no loop deformation ("Same Reference Patent" Paragraph [0010]).
[Reference Patent]
   Japanese Patent Application No. 2003-7757

However, this bonding wire had not overcome defect of weakness of bonding boundary between Au-Ag alloy bonding wire and Al and/or Al alloy pad, because of less additive of Ag, under circumstances of heavy duty of high temperature. The reason is that it brings increase of electrical resistance of bonded boundary by formation of Au₄Al bonded this Au-Ag alloy bonding wire to Al pad as general pad material when it used for semiconductor device. On the contrary, though increasing Ag additive, formation of Au-Al inter-metallic compound may be inhibited, but electrical resistivity of wire increases proportionally with amount of additives, so it does not provide a solution. Moreover, it has been known newly that halogen ion in the molded resin reacts with Au₄Al and decreases mechanical strength of bonding boundary in the case of molding this semiconductor device. Besides, though this wire has higher mechanical strength, but it is worse at bonding reliability of Al pad than pure Au wire such as purity of more than 99.99 mass % Au because of existence of Ag which forms continuous solid solution.

### DISCLOSURE OF INVENTION

### ISSUES TO BE SOLVED BY THE PRESENT INNVENTION

The present invention has been done to solve the above issues. The present invention aims to provide bonding wire which has the same level of mechanical strength of Au-1 mass % Pd alloy and high bonding reliability by anti-erosion characteristics of inter-metallic compound of Au₄Al formed at bonding section, and inhibiting formation of inter-metallic compound of Au₄Al, and sustaining the electrical resistivity of the wire as same as Au wire of it, adding less additive volume of Ag. Moreover, the present invention aims to provide semiconductor device connected Al and/or Al alloy pad, especially Al pad with using this bonding wire. The present invention aims to provide as well as bonding structure of connection Al and/or Al alloy pad, especially Al pad with using this bonding wire.

### ISSUES TO BE SOLVED BY THE PRESENT INVENTION

The inventors of the present invention investigated the generated volume of inter-metallic compound at bonding boundary after exposure of high temperature environment using the wire, which had some partial additives with less additive of Ag, formed thin bonding wire, and bonded to Al pad. Consequently, it was confirmed that partial additive of Be, Ca and Y has no effect to inhibit growth of inter-metallic compound such as Au₄Al, though these additives has been well known to enhance mechanical strength to purity of more than 99.99 mass % of Au. After all, the inventors of the present invention discovered that there are inhibiting effects to growth of inter-metallic compound such as Au₄Al among the first group of Si, Ge and Mg and the second group of Al and Cu adding with Ag, after investigation on various partial additives. The same results have gotten in the case of substitution of Al pad to Al alloy pad. However, Mg should not be applied as simple partial additive because of increase of electrical resistivity. For instance, bonding reliability of bonding wire is improved by adding 120 mass ppm of Mg. However, it was found that this bonding wire could not be used for in-vehicle device and high-speed device because of increase of electrical resistivity of 0.1 - 0.2 micro-ohm-cm. Hence, Mg is available to substitute Si or Ge within the range of obstacle of electrical resistivity of Au-Ag alloy or under the condition of the range to keep same level of electrical resistivity of purity of 99.99 mass % of Au. Criteria of the same level of electrical resistivity of purity of 99.99 mass % of Au here, is defined as within 10 % increase of it to pure Au, considering heat generation.

### (Ag)

As we have seen, Ag forms Au-Ag alloy solved as continuous solid solution in the case of small amount of it. It is considered that Au-Ag alloy is formed as atomic Ag is interspersed among every lattice of Au. For this reason, it is formed Au-Al inter-metallic compound such as Au₄Al at bonding boundary between Au and Al. However, it is considered that under co-existence of at least one element of Ge, Si, Al and Cu, this atomic Ag inhibits to form inter metallic compound of Au-Al. The more Ag adding causes the higher electrical resistivity. Therefore, it generates wrong effect such as delay of response speed of signals and malfunction of semiconductor device by heat of bonding wire. Finally, the upper limit of Ag addition is defined as 0.3 mass % of Ag in order to meet to the same level of electrical resistivity of purity of 99.99 mass % of Au. In the case of the upper limit of Au-0.3 mass % Ag alloy without any partial additives, the electrical resistivity of bonding wire is less than 2.5 micro-ohm-cm. This value means availability of less increase of electrical resistivity range compared with the value of 2.3 micro-ohm-cm. Hence, in the case of adding partial additives to this Au-Ag alloy, it is possible to inhibit heat generation relatively. Moreover, this Au-Ag alloy with partial additives does not make delay of response speed of signals. The electrical resistivity of the Au-Ag alloy wire is preferable to be as possible as small, it prefers to be less than 2.5 micro-ohm-cm in the case of adding partial additives to the Au-Ag alloy. Because, it is possible to keep heat generation at the same level as same as purity of 99.99 mass % of Au. What the electrical resistivity is less than 2.4 micro-ohm-cm is more preferable, if wrong effect of heat to semiconductor device is considered.
On the other hand, adding less volume of Ag, effect to form Au-Ag alloy is not obtainable, only effect of partial additives to Au occurs, consequently, it becomes impossible to inhibit formation of Au-Al inter-metallic compound. Therefore, the lower limit of Ag is defined as 0.02 mass % of Ag.

### (Si or Ge)

It was found that Si or Ge inhibits growth of Au-Al inter-metallic compound such as Au₄Al and sustains bonding reliability of bonding wire. It is considered that Si or Ge precipitates at grain boundary of Au-Ag alloy and inhibits diffusion of Au and growth of Au-Al inter-metallic compound. Moreover, since Si is one element to alloy to Al in the Al pad, when ball bonding of Au-Ag bonding-wire, Si has effect to loosen concentration gradient by thermal diffusion at bonding boundary and diffusion speed of Al into Au-Ag alloy becomes slow. This functional effect is same to contents of description hereinafter. Adding total of more than 200 mass ppm of at least one element of Si and/or Ge, shrinkages are generated in the initial ball, and bonding strength decreases. Therefore, the upper limit of the total amount of at least one element of Si and/or Ge is defined as 200 mass ppm.
On the other hand, total amount of less than 10 mass ppm of at least one element of Si and/or Ge, precipitation amount above mentioned at Au-Ag alloy grain boundary becomes small, growth of Au-Al inter-metallic compound is not be able to inhibit. Hence, the lower limit of total amount of at least one element of Si and/or Ge is defined as 10 mass ppm.

### (Al or Cu)

It was found that Al or Cu has also same effect as same as Si or Ge and inhibits growth of Au-Al inter-metallic compound. Where, Al is principal component of pad bonded. By partial additive of this Al into Au-Al alloy bonding wire, at ball bonding, concentration gradient by thermal diffusion of narrow area between Al pad and Au-Ag alloy bonding wire is loosened, so diffusion speed of Al into Au-Ag alloy becomes slow. Therefore, it was found that there is an effect to inhibit growth of Au-Al inter-metallic compound. It is considered that the reason why concentration gradient becomes gentle is related to existence of Al in Au matrix originally and it inhibits inversion of Al from Al pad by this homogenously scattered Al, consequently thermal diffusion is delayed, concentration gradient becomes gentle.
This effect of partial additive of Al was observed not only in the case of co-additive of Cu but also in the case of co-additive of Si or Ge. Moreover, it was found that Cu also to be alloyed into Al alloy pad, concentration gradient becomes gentle by thermal diffusion at ball bonding, Al diffusion into Au-Ag alloy is delayed, thus Cu has the same functional effect of partial additive of Al.
Total of more than 200 mass ppm of at least one element of Al and/or Cu adding becomes difficult to keep the electrical resistivity at same level of more than 99.99 mass % Au, anxiety such as signal delay increases. Therefore, the upper limit of the total amount of at least one element of Al and/or Cu is defined as 200 mass ppm.
On the other hand, in the case of total amount of less than 10 mass ppm of at least one element of Al and/or Cu, concentration gradient by thermal diffusion of Al or Cu at near Au-Ag alloy grain boundary becomes steep, and growth of Au-Al inter-metallic compound is not be able to inhibit. Hence, the lower limit of total amount of at least one element of Al and/or Cu is defined as 10 mass ppm.

### Co-additive of (Si or Ge) and (Al or Cu)

Co-additive of Si or Ge and Al or Cu aims to loosen concentration gradient by thermal diffusion at bonding boundary between Au-Ag alloy bonding wire and Al pad. By this co-additive, diffusion speed at bonding boundary is delayed and it is possible to be delayed Au diffusion by precipitation of Si and Ge at Au grain boundary.

From the above mentioned, Au alloy bonding wire of the present invention is comprised: 0.02 - 0.3 mass % Ag, and 10 - 200 mass ppm of total at least one element of Ge and/or Si, and residual Au.

Moreover, Au alloy bonding wire of the present invention is comprised: 0.02 - 0.3 mass % of Ag, 10 - 200 mass ppm of total of at least one element of Al and/or Cu, and residual Au.

Moreover, Au alloy bonding wire of the present invention is comprised: 0.02 - 0.3 mass % of Ag, 10 - 200 mass ppm of total at least one element of Ge and/or Si, and 10 - 200 mass ppm of total of at least one element of Al and/or Cu, and residual Au.

Moreover, semiconductor device of the present invention is comprised: Al pads or Al alloy pads bonded with Au alloy bonding wires, which are composed with 0.02 - 0.3 mass % of Ag, 10 - 200 mass ppm of total of at least one element of Al and/or Cu, and residual Au.

Moreover, semiconductor device of the present invention is comprised: Al pads or Al alloy pads bonded with Au alloy bonding wires, which are composed with 0.02 - 0.3 mass % of Ag, 10 - 200 mass ppm of total of at least one element of Al and/or Cu, and residual Au.

Moreover, semiconductor device of the present invention is comprised: Al pads or Al alloy pads bonded with Au alloy bonding wires, which are composed with 0.02 - 0.3 mass % of Ag, 10 - 200 mass ppm of total of at least one element of Ge and/or Si, and 10 - 200 mass ppm of total of at least one element of Al and/or Cu, and residual Au.

### EFFECTS OF THE PRESENT INNVENTION

As mentioned hereinbefore, since Au alloy bonding wire on the present invention inhibits growth of inter-metallic compound of Au-Al, it is possible to maintain bonding reliability under high temperature circumstances. Moreover, bonding by using this Au-Ag alloy to Al and/or Al alloy pad, since it is possible to maintain bonding reliability of bonding wire under room temperature, in spite of the use environment such as high temperature or room temperature, the wire is available to use for semiconductor device. Moreover, this structure of bonding between Au-Ag alloy and Al and/or Al alloy pad is stable under high temperature circumstances, and the bonding reliability to semiconductor device has been able to maintain. The Au alloy wire for bonding on the present invention provides superior effect for industry.

### DESCRIPTION OF THE MOST PREFERRED EMBODIMENT

The most preferred embodiment is attained when Au-Ag alloy includes Ge and Si, and all partial additives of Al and Cu, and also amount as additive Ag is more than total additive of these partial additives, especially under high temperature circumstances if amount of Ag is in the range of 5 -10 times of total amount of partial additives, consequently stable bonding reliability is obtained, because of stable Au-Al inter-metallic compound formation.

As shown in Table 1, Au-Ag alloy wire for bonding wire of 25 µm diameter (described as the present invention wire hereinafter) depicted as No.1 - 24, and Au-Ag alloy wire for control bonding wire (described as the control wire hereinafter) depicted as No. 25 - 31 were manufactured, after Au-Ag alloy which has the composition shown in Table 1 was melted and cast and drawn into wire. The results of measurement of electrical resistivity are shown in the right column of Table 1. On each measurement of this, 5 wire examples were used and the mean was obtained. The electrical resistivity of the above mentioned was obtained by using the method of 4 terminals of digital multi meter and was calculated from equation of electrical resistivity (micro-ohm-cm) = resistance (ohm) x section area of Au alloy wire for bonding (cm²) / 10 (cm) x 10⁶ under the condition of room temperature and the 100 mm of mark point-to-point distance. Then, the examples of the present invention wire 1 -24 and the control wire 25 - 31 on the wire bonder (Brand name: Maxµm plus) made by Kulicke & soffa were set, and were bonded to 60 µm square pad consist of Al - 0.5 mass Cu alloy mounted semiconductor IC chip under the condition of heating temperature: 200 degree in Celsius, loop length: 5 mm, loop height: 220 µm, diameter of compressed bonded ball: 54 µm, height of compressed bonded ball: 8 µm, and evaluation of bonding reliability at high temperature and room temperature was done.

### (Bonding reliability Evaluation Test at room temperature)

Bonded example (for each number of example of 100 pieces) was hitched to the tool at meandered portion (kink) of the loop just upward portion of compressed bonded ball, pull test was done.
Fracture by pull test occurs either at neck portion of wire, or at boundary between ball and pad in the mode of ball lift. Therefore, in the case of neck mode fracture, bonding with ball and pad is judged as good. By observing compressed bonded ball, case of all neck mode fractures was evaluated as "G", and case of even one ball lift mode fracture was evaluated as "W".
From the results shown in Table 1, the electrical resistivity of all wires is the range of 2.31 - 2.62, for alloyed composition of the present invention range above mentioned, and also among control wires, in the case of adding partial additives of Ge, Si, Al and Cu to Au-Ag alloy which has low additive volume of Ag, the electrical resistivity has rather low value as same as the present invention. Further, example of Au-1 mass Pd alloy is shown as control wire 31.
Moreover, also on bondability at room temperature, decline of reliability is shown, as the range of Ag or partial additives is out of the range of present invention, like example No. 26, 29 and 30.

### (Reliability of bonding after high temperature exposure)

Moreover, Kirkendall voids were generated by difference of diffusion speed between Au and Al in process of growth of inter-metallic compound, and cracks were generated at boundary between Au and inter-metallic compound. When these voids and cracks are generated, bonding strength declines. If there is conductive portion, electricity may flow, even if decline of bonding strength was generated, but it cannot be denied that bonding becomes unstable.
In order to evaluate occurrence of voids and cracks, pull strength was measured after 200 hours at 175 degree in Celsius.
When occurrence of voids and cracks increases, then between ball and Al-pad, bonding strength decreases, and percentage of fracture mode of ball lift increases.
Percentage of ball lift in fracture mode of 0 % - 10 % is depicted "E" as in excellence, 10 % - 20 % is depicted "G" as in good, 20 % - 50 % is depicted "F" as in fair, more than 50 % is depicted "B" as in bad.
Further, rising ratio of electrical resistance was evaluated as follows.
The wire was bonded to TEG (Test Element Group) chip die bonded to lead frame and was formed electrical circuit, and then this example was molded with resin. This example was kept for 1,000 hours in the air at 175 degree in Celsius, the electrical resistance of the example was measured, then the rising ratio was obtained from the value measured in advance right after molding. Less than 20 % of rising ratio is shown in "E", 20 % - 50 % of it is shown in "G" and over 50 % of it is shown in "B". Each evaluation result is shown in right column of Table 1.
The result in Table 1 on bonding reliability is "defect" to each example of No. 25, 28 and 29, and is "failure" to No.27.

Moreover, on the present invention wire 1 - 24 and the control wire 25 - 31, anti-flow ability to resin was evaluated.

### (Anti flow ability to resin)

Substrate mounted semiconductor IC chip bonded under condition of loop length: 3.5 mm, and loop height: 220 µm, after this substrate was molded by epoxy resin using molding equipment, then X-ray is projected onto internal semiconductor chip resin molded using soft X-ray non-distractive inspection equipment, amount of flow at maximum wire flow was measured, anti-flow ability is defined as the value (%) divided by the loop length, thus this anti-flow ability to resin was evaluated. Less than 3 % of anti-flow ability is shown in "E", 3 % - 5% of it is shown in "G", more than 5 % of it is shown in "B" in right column of Table 1. Each evaluation result is shown in right column of Table 1.

### [Table 1]

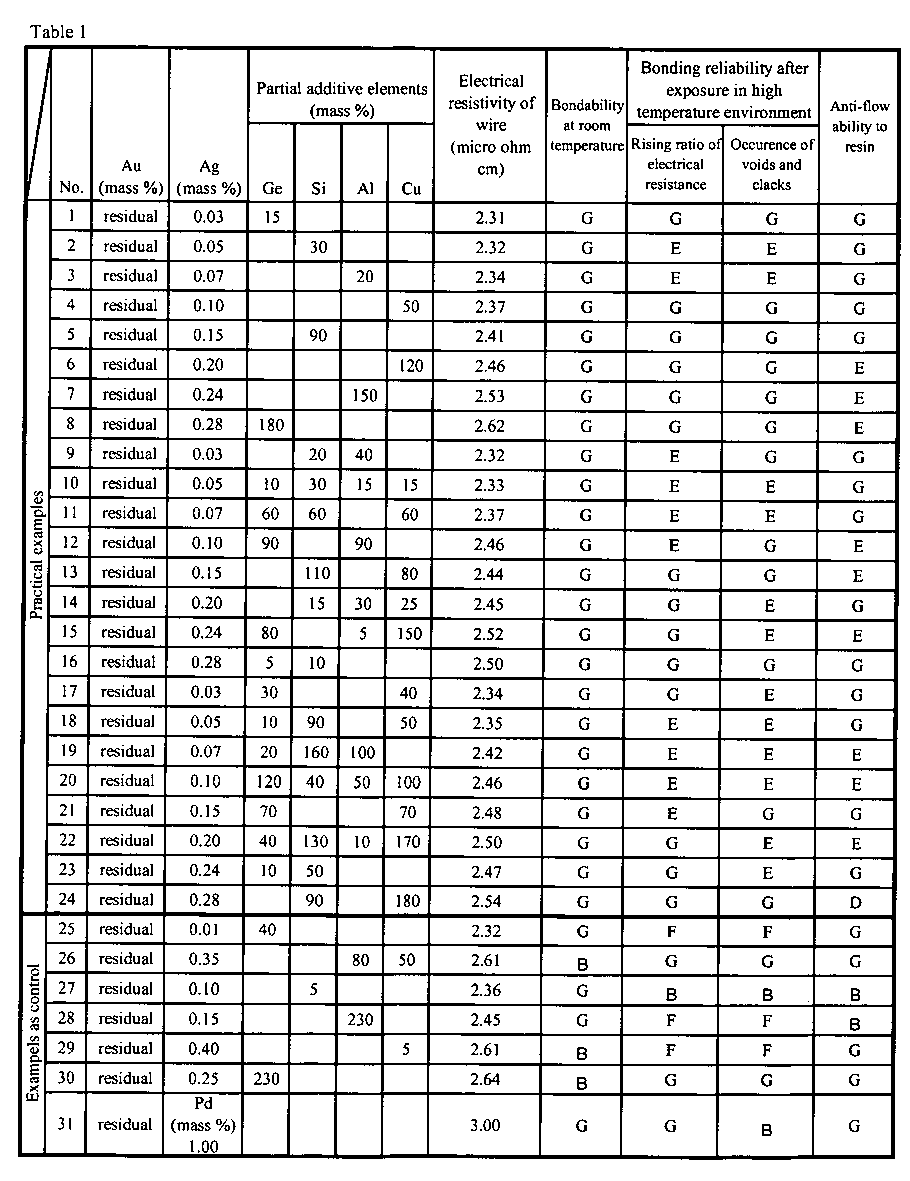

Seeing the result of "anti-flow ability to resin", the example No. 27 and 28 are "failure"; from these results, even though volume of additive Ag is within the range of the present invention, it is found that enough strength cannot be obtained if partial additives are out of the range.

As above mentioned, shown in the right column of Table 1, the present invention wire sustains rather small increase of electrical resistivity, and it is excellent at bonding reliability and anti-flow ability, but it is found that control wire 25 - 31 becomes defect at least on one of these characteristics.

### POSSIBILITY FOR INDUSTRIAL USE

As above mentioned, Au alloy bonding wire of the present invention has the almost same value of low electrical resistivity near to pure Au bonding wire of the purity of 99.99 mass % Au of it, it is superior at bonding reliability at room temperature and also high temperature to Al and/or Al alloy pad, also it has enough strength and stiffness to anti-flow ability, it is applicable to in-vehicle semiconductor device and semiconductor device for high speed work for high temperature environment use, furthermore, it meets to needs of thinner wiring promoted with finer pitching, it is envisaged that it may use broadly in the field of these semiconductor devices among industry.

## Claims

1. Au alloy bonding wire comprising: 0.02 - 0.3 mass % Ag, and 10 - 200 mass ppm of total at least one element of Ge and/or Si, and residual Au.

2. Au alloy bonding wire comprising: 0.02 - 0.3 mass % of Ag, 10 - 200 mass ppm of total of at least one element of Al and/or Cu, and residual Au.

3. Au alloy bonding wire comprising: 0.02 - 0.3 mass % of Ag, 10 - 200 mass ppm of total at least one element of Ge and/or Si, and 10 - 200 mass ppm of total of at least one element of Al and/or Cu, and residual Au.

4. Semiconductor device comprising: Al pads or Al alloy pads bonded with Au alloy bonding wires, which are composed with 0.02 - 0.3 mass % of Ag, 10 - 200 mass ppm of total of at least one element of Ge and/or Si, and residual Au.

5. Semiconductor device comprising: Al pads or Al alloy pads bonded with Au alloy bonding wires, which are composed with 0.02 - 0.3 mass % of Ag, 10 - 200 mass ppm of total of at least one element of Al and/or Cu, and residual Au.

6. Semiconductor device comprising: Al pads or Al alloy pads bonded with Au alloy bonding wires, which are composed with 0.02 - 0.3 mass % of Ag, 10 - 200 mass ppm of total of at least one element of Ge and/or Si, and 10 - 200 mass ppm of total of at least one element of Al and/or Cu, and residual Au.
